Europäisches Patentamt

European Patent Office

Office européen des brevets

(11) Publication number: **0 063 273**
**B1**

# EUROPEAN PATENT SPECIFICATION

(45) Date of publication of patent specification: **12.02.86**

(51) Int. Cl.⁴: **H 01 J 37/32, H 01 L 21/306**

(21) Application number: **82102748.9**

(22) Date of filing: **31.03.82**

(54) **Discharge system for plasma processing.**

(30) Priority: **02.04.81 US 250364**

(43) Date of publication of application:
**27.10.82 Bulletin 82/43**

(45) Publication of the grant of the patent:
**12.02.86 Bulletin 86/07**

(84) Designated Contracting States:
**CH DE FR GB IT LI NL**

(56) References cited:
US-A-3 476 971
US-A-3 984 301
US-A-4 030 967
US-A-4 175 235
US-A-4 209 357
US-A-4 253 907

(73) Proprietor: **THE PERKIN-ELMER CORPORATION**
**Main Avenue**
**Norwalk Connecticut 06856 (US)**

(72) Inventor: **Reinberg, Alan R.**
**2 Charbeth Lane**
**Westport Connecticut (US)**
Inventor: **Steinberg, George N.**
**17 Jennings Court**
**Westport Connecticut (US)**

(74) Representative: **Patentanwälte Grünecker, Dr. Kinkeldey, Dr. Stockmair, Dr. Schumann, Jakob, Dr. Bezold, Meister, Hilgers, Dr. Meyer-Plath**
**Maximilianstrasse 58**
**D-8000 München 22 (DE)**

Courier Press, Leamington Spa, England.

## Description

The invention relates to an apparatus for the downstream etching of semiconductor devices, comprising in combination an etching chamber containing the semiconductor device to be etched, a tube having a discharge chamber connected between a source of etching gas and said etching chamber and a pair of electrodes disposed in said discharge chamber.

Such an apparatus is known from US—PS 41 75 235. This patent describes an apparatus for the so-called downstream etching technique. In this technique, plasma is created outside the main etching chamber with the reactive species being transported to the main chamber or auxilliary chamber where the etching takes place. Downstream etching is a specialized form of etching and is used, e.g., to strip remaining photoresist form the substrate as well as to remove materials such as polycrystalline silicon and silicon nitride. While the generating of the plasma by the subjecting of the etching gas to R.F. or radio frequence power, microwaves or the like external to the tube has the disadvantage that necessarily high voltage and frequency must be used, to overcome the high impedance of the tube through which the etching gas must pass, this above mentioned apparatus uses internal electrodes, so that only low frequency power is necessary. The internal electrodes can generate the required plasma, these electrodes, however, sputter creating loosely bonded particles or dust which are transported downstream along with the etching plasma which deposits on the wafer in quantity which often effectively destroys the usefulness of the wafers which must then be discarded.

From the US—PS 40 30 967, it is known that during operation of a plasma etching apparatus, the electrodes are liable to sputter, thereby releasing contaminants that can ruin the work pieces. To obviate this problem, the use of electrodes made of carbon or silicon carbide is proposed, however, according to this solution, the electrodes should be made of a conductor relatively inert to the plasma.

It is the task of the present invention to provide an apparatus of the afore-mentioned type which permits plasma generation by a low frequency power source without the disadvantage of loose particles formation.

According to the invention, this task is solved by an apparatus, as stated above, in which the electrodes of the discharge chamber are made of a material which chemically reacts with the plasma products created when the etching gases in said tube are excited to form an etching plasma and the material of the electrode is chosen such, that the products of the chemical reaction are volatile species, which are devoid of loosely bonded particles and/or dust. The electrodes, as used according to the invention, are of a material which reacts chemically to produce a volatile species devoid of particles so that the etching plasma entering said etching chamber is substantially particle free. The volatile species may then be pumped out of the etching chamber, leaving the wafer unharmed.

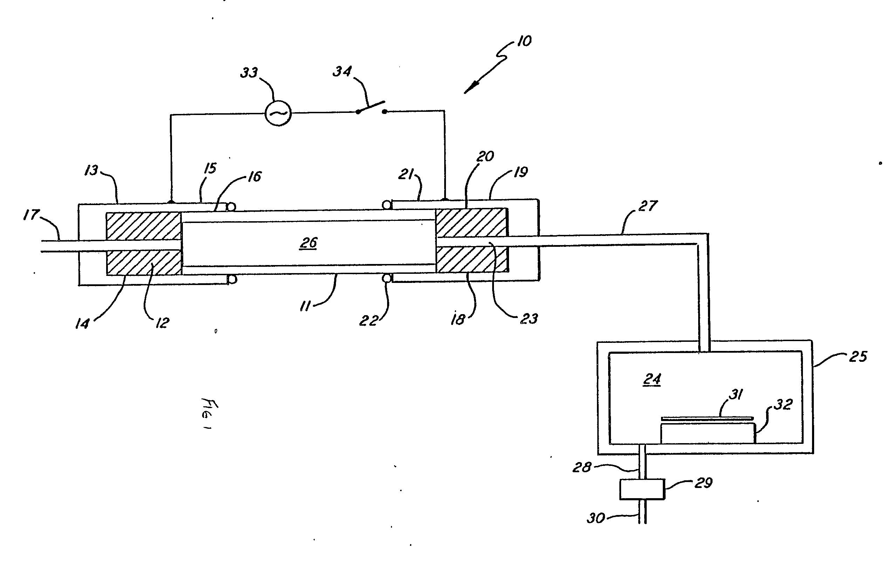

The Figure illustrates a preferred embodiment of the present invention.

Referring now more particularly to the Figure, there is known the downstream etching apparatus 10 of the present invention.

It comprises a tube 11 made of alumina or other suitable material. Disposed at one end of tube 11 is an electrode 12. The electrode 12 is made of a reactive material such as graphite, silicon or silicon carbide for reasons that will become apparent as this description proceeds.

An electrically conductive casing 13 such as, aluminum has an opening 14 in which electrode 12 is secured, e.g., by force fit. The end of tube 11 abuts electrode 12. The casing 13 has an extension 15 which forms an opening 16 for the end of tube 11 which is secured therein, e.g., by force fit holding the end of tube 11 in gas tight abutting relationship with electrode 12. An O-ring is secured on tube 11 in abutting relationship with the extension 15 of casing 13 to further ensure a gas tight fit at the end of tube 11.

Casing 13 and electrode 12 have an opening or port 17 which is connected to a source of etching gas (not shown).

In a similar manner an electrode 18 is secured within opening 20 of aluminum casing 19, e.g., by force fit. Extension 21 of casing 19 holds the other end of tube 11 in abutting gas tight relationship with electrode 18. O-Ring 22 disposed around tube 11 in abutting relationship with extension 21 of casing 19 further provides a gas tight seal between tube 11 and electrode 18. Electrode 18 and casing 19 have an opening 23 therethrough which is connected by any suitable means to conduit 27.

The inner volume 24 of etching chamber 25 communicates with the inner volume 26 of tube 11 via conduit 27. The inner volume 24 of etching chamber is connected to a pump 29 via port 28 for evacuating gases within volume 24 and maintaining pressure therein at a predetermined amount suitable for etching. In evacuating gases from etching chamber 25 the gases input into volume 26 of tube 11 are transported into chamber 25 with the products of etching leaving chamber 25 via pump 29 and port 30.

Within chamber 25 a wafer 31 to be etched is disposed on platform 32.

An A.C. source 33 of low frequency, e.g., the frequency of ordinary 60 Hz house current and 1.000 V is electrically connected to aluminum casings 13 and 19 via switch 34, as shown. Alternately, a d.c. source providing 300 watts of power may be substituted for the A.C. source. This use of a low frequency power source is possible inasmuch as electrodes 12 and 18 are located within the plasma chamber or volume 26. If the electrodes were external to volume 26, the frequency would have to be very high, i.e., the order of an R.F. frequency in the mega-hertz range.

The electrodes 12 and 18 are made of carbon (graphite), silicon or silicon carbide. These materials react chemically with the gas products created by the plasma and in so doing the formation of loosely bonded particles is avoided.

In operation when the source of etching gases is connected to tube 11 and pump 29 is on, the etching gases flow into the inner volume 26 of tube 11. When switch 34 is closed, the 60 cycle source is connected between electrodes 12 and 18 which creates a plasma of the etching gas which in the excited state flow into volume 24 of etching chamber 25 where they attack and remove the desired material.

As aforesaid, since the electrodes are internal of the volume 26 low power frequency, e.g. 60 hertz may be used. Furthermore, since the electrodes are made of graphite, silicon or silicon carbide which chemically react with the plasma products, the formation of particles or dust is avoided and therefore, do not deposit on the wafer 31 in etching chamber 25 thus eliminating damage to the wafer or the circuit patterns already built-up thereon.

When stripping photoresist from a wafer, the etching gas is composed of 1 part of $CF_4$ to 3 to 4 parts of $O_2$. When silicon is etched three parts of $CF_4$ to 1 part of $O_2$ are used for the etching gas.

Also, for both of these processes, the pressure in volumes 24 and 26 should be about 40 Pa (0.3 Torr, higher or lower pressures can be used) when gas is flowing and the discharge is on. Temperature of the walls of tube 11 is approximately 40°C and the temperature of the chamber 25 is approximately 23°C.

Other modifications of the present invention are possible in light of the above description which should not be construed as placing limitations on the invention other than those expressly set forth in the claims which follow:

**Claims**

1. An apparatus for the downstream etching of semiconductor devices, comprising in combination; an etching chamber (25) containing the semiconductor device (31) to be etched, a tube (11) having a discharge chamber (26) connected between a source of etching gas and said etching chamber, and a pair of electrodes (12, 18) disposed in said discharge chamber, said apparatus being characterised in that the electrodes of the discharge chamber are made of a material which chemically reacts with the plasma products created when the etching gases in said tube are excited to form an etching plasma, and that the material of the electrodes is chosen such that the products of the chemical reaction are volatile species, which are devoid of loosely bonded particles and/or dust.

2. An apparatus according to claim 1 wherein said electrodes (12, 18) are disposed at opposite ends of said tube (11).

3. An apparatus according to claim 2 wherein said electrodes (12, 18) are made of graphite.

4. An apparatus according to claim 2 wherein said electrodes (12, 18) are made of silicon.

5. An apparatus according to claim 4 wherein said electrodes (12, 18) are made of silicon carbide.

6. An apparatus according to claim 2 further including a low frequency power source (33) connected to said electrodes (12, 18) for creating a plasma of said etching gas in said tube (11).

7. An apparatus according to claim 6 wherein said low frequency power source (33) is a 60 hertz, 1,000 volt source.

8. An apparatus according to claim 2 further including a d.c. power source connected to said electrodes (12, 18) for creating a plasma of said etching gas in said tube.

9. An apparatus according to claim 8 wherein said d.c. power source provides approximately 300 watts of power.

10. An apparatus according to claims 1, 2, 3, 4, 5, 6, 7, 8 or 9 further including pump means (29) connected to said etching chamber (25) for evacuating said etching chamber at a predetermined rate.

11. An apparatus according to claim 10 wherein the etching gas is 1 part $CF_4$ to 3 to 4 parts $O_2$ when photoresist is being stripped from the semiconductor device (31).

12. An apparatus according to claim 10 wherein the etching gases are 3 parts $CF_4$ and one part $O_2$ when silicon is being etched.

**Patentansprüche**

1. Vorrichtung zum Stromabwärts-Ätzen (downstream etching) von Halbleiteranordnungen mit einer Ätzkammer (25), die die Halbleiteranordnung (31) aufnimmt, die der Ätzbehandlung unterzogen werden soll, mit einer Röhre (11), die eine Entladungskammer (26) aufweist, welche zwischen der das Ätzgas erzeugenden Quelle und der Ätzkammer angeschlossen ist und mit einem Elektrodenpaar (12, 18) welches in der Entladungskammer angeordnet ist, dadurch gekennzeichnet, daß die Elektroden der Entladungskammer aus einem Material bestehen, welches chemisch mit den Plasmaprodukten reagiert, die erzeugt werden, wenn das Ätzgas in der Röhre zur Bildung eines Ätzplasmas angeregt wird und daß das Elektrodenmaterial derart gewählt ist, daß die bei der chemischen Reaktion entstehenden Produkte sich verflüchtigende Stoffe sind, die frei von lose gebundenen Teilchen und/oder Staub sind.

2. Vorrichtung nach Anspruch 1, wobei die Elektroden (12, 18) an sich gegenüberliegenden Enden der Röhre (11) angeordnet sind.

3. Vorrichtung nach Anspruch 2, wobei die Elektroden (12, 18) aus Graphit bestehen.

4. Vorrichtung nach Anspruch 2, wobei die Elektroden (12, 18) aus Silizium bestehen.

5. Vorrichtung nach Anspruch 4, wobei die Elektroden (12, 18) aus Siliziumkarbid bestehen.

6. Vorrichtung nach Anspruch 2, die eine niederfrequente Leistungsquelle (33) umfaßt, welche an die Elektroden (12, 18) angeschlossen ist, um das Plasma des Ätzgases in der Röhre (11) zu erzeugen.

7. Vorrichtung nach Anspruch 6, wobei die niederfrequente Leistungsquelle (33) eine 60-Hertz-Quelle mit 1000 Volt ist.

8. Vorrichtung nach Anspruch 2, welche eine Gleichspannungsquelle aufweist, die zwischen den Elektroden (12, 18) angeschlossen ist, um das Plasma des Ätzgases in der Röhre zu erzeugen.

9. Vorrichtung nach Anspruch 8, wobei eine Gleichspannungsquelle verwendet wird, die ca. 300 Watt zur Verfügung stellt.

10. Vorrichtung nach Anspruch 1, 2, 3, 4, 5, 6, 7, 8 oder 9 mit einer Pumpe (29), die an die Ätzkammer (25) angeschlossen ist, um die Ätzkammer zu einem bestimmten Wert zu evakuieren.

11. Vorrichtung nach Anspruch 10, wobei das Ätzgas zum Abätzen eines Photolacks von einer Halbleitereinrichtung (31) aus einem Teil $CF_4$ und 3 oder 4 Teilen $O_2$ besteht.

12. Vorrichtung nach Anspruch 10, wobei als Ätzgas 3 Teile $CF_4$ und ein Teil $O_2$ verwendet wird, wenn Silizium geätzt wird.

**Revendications**

1. Appareil pour l'attaque en aval de dispositifs à semiconducteur, comprenant en combinaison: une chambre d'attaque (25) contenant le dispositif à semiconducteur (31) à attaquer, un tube (11) comportant une chambre de décharge (26) connectée entre une source d'un gaz d'attaque et la chambre d'attaque, et une paire d'électrodes (12, 18) placées dans la chambre de décharge, l'appareil étant caractérisé en ce que les électrodes de la chambre de décharge sont constituées d'un matériau qui réagit chimiquement avec les produits de plasma créés quand les gaz d'attaque se trouvant dans le tube sont excités pour former un plasma d'attaque, et en ce que le matériau des électrodes est choisi pour que les produits de la réaction chimique soient des corps volatils, ces corps étant dépourvus de particules faiblement liées et/ou de poussière.

2. Appareil selon la revendication 1, caractérisé en ce que les électrodes (12, 18) sont placées aux extrémités opposées du tube (11).

3. Appareil selon la revendication 2, caractérisé en ce que les électrodes (12, 18) sont constituées de graphite.

4. Appareil selon la revendication 2, caractérisé en ce que les électrodes (12, 18) sont constituées de silicium.

5. Appareil selon la revendication 4, caractérisé en ce que les électrodes (12, 18) sont constituées de carbure de silicium.

6. Appareil selon la revendication 2, caractérisé en ce qu'il comprend en outre une source d'énergie à basse fréquence (33) connectée aux électrodes (12, 18) pour créer un plasma dudit gaz d'attaque dans le tube (11).

7. Appareil selon la revendication 6, caractérisé en ce que la source d'énergie à basse fréquence (33) est une source de 1000 volts à 60 hertzs.

8. Appareil selon la revendication 2, caractérisé en ce qu'il comprend en outre une source d'énergie en courant continu connectée aux électrodes (12, 18) pour créer un plasma dudit gaz d'attaque dans le tube.

9. Appareil selon la revendication 8, caractérisé en ce que la source d'énergie en courant continu fournit une puissance d'environ 300 watts.

10. Appareil selon l'une quelconque des revendications 1 à 9, caractérisé en ce qu'il comprend en outre une pompe (29) connectée à la chambre d'attaque (25) pour l'évacuation de la chambre d'attaque à une vitesse prédéterminée.

11. Appareil selon la revendication 10, caractérisé en ce que le gaz d'attaque est composé d'une part de $CF_4$ pour 3 ou 4 parts de $O_2$ quand une couche photorésistante est détachée du dispositif à semiconducteur (31).

12. Appareil selon la revendication 10, caractérisé en ce que les gaz d'attaque sont composés de 3 parts de $CF_4$ et d'une part de $O_2$ quand du silicium est attaqué.

Fig 1